**Europäisches Patentamt**

**European Patent Office**

**Office européen des brevets**

(19)

(11) Veröffentlichungsnummer: **0 164 105**

**A2**

(12) # EUROPÄISCHE PATENTANMELDUNG

(21) Anmeldenummer: **85106923.7**

(22) Anmeldetag: **04.06.85**

(51) Int. Cl.⁴: **H 04 L 11/00**, G 06 F 13/38, H 03 M 9/00

(30) Priorität: **04.06.84 DE 3420786**

(43) Veröffentlichungstag der Anmeldung: **11.12.85 Patentblatt 85/50**

(84) Benannte Vertragsstaaten: **AT BE CH DE LI NL**

(71) Anmelder: **Siemens Aktiengesellschaft, Berlin und München Wittelsbacherplatz 2, D-8000 München 2 (DE)**

(72) Erfinder: **Wolff, Pieter, Wilhelm-Busch-Strasse 18, D-8000 München 71 (DE)**

(54) **Schaltungsanordnung zur Aufnahme und/oder zur Abgabe von seriell auftretenden Binärsignalen in bzw. von einer einen Mikrocomputer bzw. Mikroprozessor enthaltenden Verarbeitungseinrichtung.**

(57) Zur Aufnahme und/oder Abgabe von seriell auftretenden Binärsignalen in bzw. von einer einen Mikrocomputer bzw. Mikroprozessor (MC) enthaltenden Verarbeitungseinrichtung sind die seriell auftretenden Binärsignale führende Signalaufnahmeleitungen (e1 bis e3) über individuelle bistabile Kippglieder (Ke1 bis Ke3) an einem Eingang (se) des Mikrocomputers bzw. Mikroprozessors (MC) angeschlossen, und Signalabgabeleitungen (a1 bis a3) sind über individuelle bistabile Kippglieder (Ka1 bis Ka3) an Ausgänge des Mikrocomputers bzw. Mikroprozessors (MC1) angeschlossen. In dem Mikrocomputer bzw. Mikroprozessor (MC1) werden die seriell auftretenden Binärsignale für eine Verarbeitung in Parallelsignale umgesetzt, und die verarbeiteten Parallelsignale werden wieder in serielle Signale für eine Signalabgabe umgesetzt.

EP 0 164 105 A2

_-1-_

Siemens Aktiengesellschaft                    Unser Zeichen
Berlin und München                            VPA 84 P 1423 E

                              <u>Auslandsfassung</u>

Schaltungsanordnung zur Aufnahme und/oder zur Abgabe von
seriell auftretenden Binärsignalen in bzw. von einer einen
Mikrocomputer bzw. Mikroprozessor enthaltenden Verarbei-
<u>tungseinrichtung</u>

Die Erfindung bezieht sich auf eine Schaltungsanordnung zur
Aufnahme von auf einer Mehrzahl von Signalaufnahmeleitungen seriell auftretenden Binärsignalen und Verarbeitung dieser Binärsignale in Form von jeweils eine vorgegebene Anzahl von Bits umfassenden Parallelsignalen und/oder zur
Abgabe von seriell auftretenden Binärsignalen über einzelne Signalabgabeleitungen nach zuvor erfolgter Verarbeitung
von jeweils die vorgegebene Anzahl von Bits umfassenden
Parallelsignalen in bzw. von einer einen Mikrocomputer
bzw. Mikroprozessor enthaltenden Verarbeitungseinrichtung,
die eingangs- und/oder ausgangsseitig über Signalaufnahme-
bzw. Signalabgabeeinrichtungen mit den Signalaufnahme- bzw.
Signalabgabeleitungen verbunden ist.

Die derzeit üblicherweise in Verarbeitungseinrichtungen
verwendeten Mikrocomputer bzw. Mikroprozessoren sind so ausgelegt, daß sie Binärsignale jeweils in Form von Parallelsignalen zu verarbeiten vermögen. Wenn ein serieller Datenstrom aufzunehmen bzw. abzugeben ist, werden zwischen
den entsprechenden Empfangsleitungen bzw. Sendeleitungen
und dem jeweiligen Mikrocomputer bzw. Mikroprozessor gesonderte Schnittstellenbausteine eingesetzt. Ein derartiger Schnittstellenbaustein ist beispielsweise ein universeller Synchron/Asynchron-Sender/Empfänger-Baustein,
der auch als USART-Baustein bekannt ist. Solch ein Schnittstellenbaustein meldet dem mit ihm verbundenen Mikro-
Nt 1 Phl / 4.6.1984

computer bzw. Mikroprozessor, wenn er ein neues Parallelsignal bzw. -zeichen für die Übertragung annehmen oder ein
solches Zeichen bzw. Parallelsignal an den Mikrocomputer
bzw. Mikroprozessor abgeben kann. Auf diese Weise lassen
sich zwar mit Hilfe eines Mikrocomputers bzw. Mikroprozessors Binärsignale verarbeiten, die über eine Vielzahl
von für eine serielle Signalübertragung ausgelegten Leitungen zugeführt bzw. weitergeleitet werden. Von Nachteil dabei ist jedoch, daß der mit der Bereitstellung derartiger
Schnittstellenbausteine verknüpfte Aufwand relativ hoch
ist. Hinzu kommt noch, daß die Preise derartiger Schnittstellenbausteine in der Größenordnung der Preise für Microprozessoren liegen.

Der Erfindung liegt demgemäß die Aufgabe zugrunde, einen
Weg zu zeigen, wie bei einer Schaltungsanordnung der eingangs genannten Art mit relativ geringem schaltungstechnischem Aufwand ausgekommen werden kann, um auf Empfangsleitungen seriell auftretende Binärsignale für die Verarbeitung durch den Mikrocomputer bzw. Mikroprozessor erfassen
bzw. von dem Mikrocomputer bzw. Mikroprozessor verarbeitete Parallelsignale in Form von seriell auftretenden Binärsignalen über Sendeleitungen abgeben zu können.

Gelöst wird die vorstehend aufgezeigte Aufgabe bei einer
Schaltungsanordnung der eingangs genannten Art erfindungsgemäß dadurch, daß die Signalaufnahmeeinrichtungen durch
den Signalaufnahmeleitungen individuell zugehörige bistabile Kippglieder gebildet sind, welche taktgesteuert die
auf den einzelnen Signalaufnahmeleitungen auftretenden
Bits aufnehmen und die betreffenden Bits ausgangsseitig
über eine Auswahlschaltung an einen Eingang des ebenfalls taktgesteuerten Mikrocomputers bzw. Mikroprozessors
abzugeben gestatten, daß dem betreffenden Eingang in dem
Mikrocomputer bzw. Mikroprozessor wenigstens ein interner
Speicher bzw. wenigstens ein internes Register zur Aufnahme
der seriell auftretenden Bits in einzelnen Speicher- bzw. Registerzellen und
zur Abgabe jeweils eines Parallelsignals für die Verarbeitung nach Aufnahme von Bits in der genannten vorgegebenen Anzahl zugeordnet ist, und daß die Signalabgabeeinrichtungen durch
einzelne, ebenfalls taktgesteuerte bistabile Kippglieder
gebildet sind, welche ausgangsseitig jeweils direkt mit den
einzelnen Signalabgabeleitungen verbunden sind und welche
eingangsseitig die von der Ausgangsseite des Mikrocomputers
bzw. Mikroprozessors seriell bereitgetellten Bits aufnehmen,
die aus einzelnen Speicher- bzw. Registerzellen wenigstens eines
in dem Mikrocomputer bzw. Mikroprozessor als Abgabespeicher
bzw. Abgaberegister vorgesehenen internen Speichers bzw. Registers abgegeben werden, der bzw. das auf entsprechende
Verarbeitungsvorgänge hin Parallelsignale zugeführt erhält.

Die Erfindung bringt den Vorteil mit sich, daß mit einem
besonders geringen schaltungstechnischen Aufwand ausgekommen werden kann, um auf einer Mehrzahl von Empfangsleitungen seriell auftretende Binärsignale für eine einen Mikrocomputer bzw. Mikroprozessor enthaltende Verarbeitungseinrichtung  aufnehmen zu können, welche lediglich Parallelsignale zu verarbeiten vermag, und/oder von dieser Verarbeitungseinrichtung Binärsignale seriell über eine Vielzahl von Sendeleitungen abgeben zu können. Gemäß der Erfindung wird für die Signalaufnahmeeinrichtungen und für
die Signalabgabeeinrichtungen mit nur einem Eingang des
Mikrocomputers bzw. Mikroprozessors für mehrere Empfangsleitungen ausgekommen; die Verwendung von relativ aufwendigen Schnittstellenbausteinen, wie sie üblicherweise in
Verbindung mit Mikrocomputern bzw. Mikroprozessoren verwendet werden, ist hier also entbehrlich.

Zweckmäßigerweise sind die die Signalabgabeeinrichtungen
bildenden bistabilen Kippglieder mit ihren Signaleingängen
an einzelne Ausgänge des Mikrocomputers bzw. Mikroprozessors angeschlossen, welche durch individuelle Aktivierung jeweils einzeln mit dem genannten Ausgabespeicher bzw.

Ausgaberegister verbindbar sind. Hierdurch ergibt sich der Vorteil eines besonders geringen schaltungstechnischen Aufwands für die Verbindung der Signalabgabeeinrichtungen mit dem Mikrocomputer bzw. Mikroprozessor.

Vorzugsweise ist die mit der Ausgangsseite der die Signalaufnahmeeinrichtungen bildenden bistabilen Kippglieder verbundene Auswahlschaltung durch eine Multiplexerschaltung gebildet, welche durch eine Steuerschaltung gesteuert jeweils nur eines der betreffenden bistabilen Kippglieder mit dem Eingang des Mikrocomputers bzw. Mikroprozessors wirksam verbindet. Hierdurch ergibt sich der Vorteil eines relativ geringen schaltungstechnischen Aufwands für die Verbindung der einzelnen Signalaufnahmeeinrichtungen mit dem Mikrocomputer bzw. Mikroprozessor.

Zweckmäßigerweise ist die Multiplexerschaltung eingangsseitig an zu zwei Gruppen von Signalaufnahmeleitungen gehörende Signalaufnahmeleitungen angeschlossen, und aus jeder Gruppe der betreffenden Leitungen wird jeweils eine Signalaufnahmeleitung ausgewählt; die Multiplexerschaltung ist dabei ausgangsseitig mit jeweils einem gesonderten Eingang des Mikrocomputers bzw. Mikroprozessors verbunden. Hierdurch ergibt sich der Vorteil, daß auf relativ einfache Weise zu zwei verschiedenen Gruppen von Signalaufnahmeleitungen gehörende Signalaufnahmeleitungen bezüglich der über sie seriell übertragenen Binärsignale berücksichtigt werden können.

Anhand einer Zeichnung wird die Erfindung nachstehend beispielsweise näher erläutert.

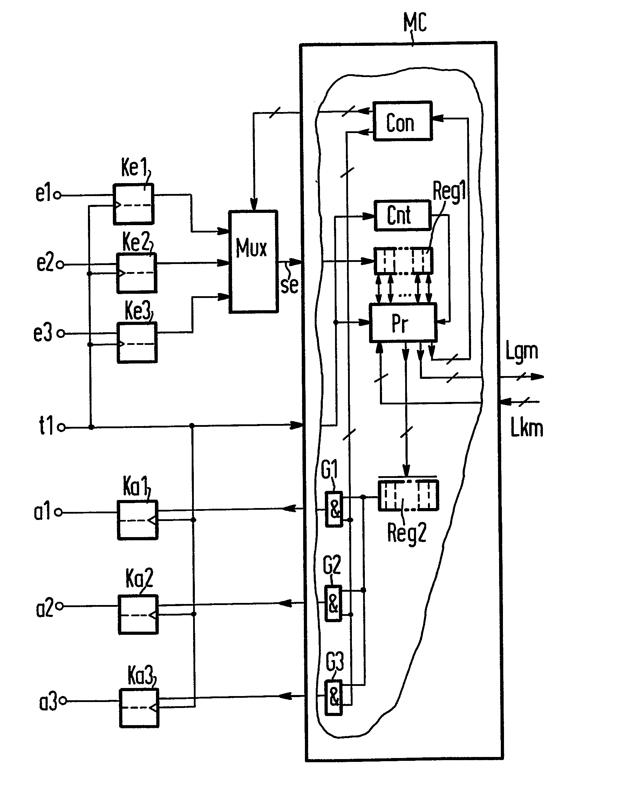

In der Zeichnung ist schematisch eine Schaltungsanordnung gezeigt, die eine Mehrzahl von Signalaufnahmeleitungen, nämlich im vorliegenden Fall drei Signalaufnahmeleitungen el, e2, e3, und eine Mehrzahl von Signalabgabeleitungen, nämlich im vorliegenden Fall drei Signalabgabeleitungen al, a2 und a3, aufweist. Über diese Leitungen, die Datensignalleitungen entsprechend der CCITT-Empfehlung X.21 sein können, werden die einzelnen Bits der Datensignale bildenden Binärsignale jeweils seriell übertragen. Den Signalaufnahmeleitungen el bis e3 sind im vorliegenden Fall durch einzelne bistabile Kippglieder gebildete Signalaufnahmeeinrichtungen individuell zugehörig. Der Signalaufnahmeleitung el ist das bistabile Kippglied Kel zugehörig, der Signalaufnahmeleitung e2 ist das bistabile Kippglied Ke2 zugehörig, und der Signalaufnahmeleitung e3 ist das bistabile Kippglied Ke3 zugehörig. Diese bistabilen Kippglieder sind taktgesteuerte Kippglieder, die mit ihren Takteingängen gemeinsam an einem Taktanschluß tl angeschlossen sind und deren Signaleingänge mit den erwähnten Signalaufnahmeleitungen el, e2 bzw. e3 verbunden sind.

Den Signalabgabeleitungen al, a2, a3 sind individuell Signalabgabeeinrichtungen in Form von einzelnen bistabilen Kippgliedern Kal, Ka2, Ka3 zugehörig. Die betreffenden Signalabgabeleitungen sind dabei mit den Ausgängen der erwähnten bistabilen Kippglieder verbunden. Diese Kippglieder sind ebenfalls taktgesteuerte Kippglieder, die mit ihren Takteingängen gemeinsam an dem bereits erwähnten Taktanschluß tl angeschlossen sind. Mit ihren Signaleingängen sind die betreffenden bistabilen Kippglieder Kal, Ka2, Ka3 an gesonderten Ausgängen eines zu einer Verarbeitungseinrichtung gehörenden Mikrocomputers bzw. Mikroprozessors MC angeschlossen.

Der erwähnte Mikrocomputer bzw. Mikroprozessor MC ist mit einem gesonderten Eingang se über eine Multiplexerschaltung Mux mit den Ausgängen der die bereits erwähnten Signalaufnahmeeinrichtungen bildenden bistabilen Kippglieder Kel, Ke2, Ke3 verbunden.

Die gerade erwähnten Ausgänge und der zuvor erwähnte Eingang des Mikrocomputers bzw. Mikroprozessors
MC können jeweils ein gesonderter Anschluß (Port) des betreffenden Mikrocomputers bzw. Mikroprozessors MC sein.
Es ist aber auch möglich, von den üblicherweise für eine
Datensignalübertragung zur Verfügung stehenden parallelen
Datenanschlüssen eines Mikrocomputers bzw. Mikroprozessors
jeweils lediglich einen einzigen Anschluß als Ausgang bzw. Eingang zu verwenden.

Bezüglich des zu einer Verarbeitungseinrichtung gehörenden in der Zeichnung gezeigten Mikrocomputers bzw. Mikroprozessors MC ist unter anderem ein zentraler Prozessorteil Pr angedeutet, der ebenfalls mit dem Taktanschluß
tl verbunden sein mag und der mit Paralleleingängen an
den Ausgängen eines internen Registers Regl angeschlossen
ist. Dieses interne Register, das gegebenenfalls auch
durch einen internen Speicher des Mikrocomputers gebildet
sein kann, ist mit einem Eingang mit dem Ausgang
der Multiplexer-Schaltung Mux verbunden. Mit dem Taktanschluß tl ist ferner ein Zähler Cnt mit einem Zähleingang
verbunden. Dieser Zähler Cnt ist ausgangsseitig mit dem
zentralen Prozessorteil Pr verbunden. Der betreffende
Zähler Cnt zählt die Anzahl der in das interne Register
Regl seriell eingeschriebenen Bits und gibt nach Erreichen einer vorgegebenen Anzahl von m Bits ein Steuersignal an den zentralen Prozessorteil Pr ab. Dieser Prozessorteil Pr kann daraufhin den Inhalt des internen
Registers Regl als Parallelsignal übernehmen und weiter
verarbeiten. An dieser Stelle sei angemerkt, daß betreffende zentrale Prozessorteil Pr durch das in Mikroprozessoren jeweils vorhandene Rechenwerk ALU gebildet sein
kann.

Der zuvor erwähnte zentrale Prozessorteil Pr sei so ausgelegt, daß er jeweils m Bits umfassende Parallelsignale aufzunehmen und zu verarbeiten vermag. Derartige Parallelsignale nimmt der betreffende zentrale Prozessorteil zum einen von der Ausgangsseite des betrachteten internen Registes Reg1 auf, und zum anderen gibt der betreffende Prozessorteil derartige Parallelsignale ausgangsseitig über Parallelleitungen ab, die mit den außerhalb des Mikrocomputers bzw. Mikroprozessors MC angedeuteten Parallelleitungen Lgm verbunden sind. An dieser Stelle sei angemerkt, daß die jeweils durch einen Querstrich markierten Verbindungsleitungen Parallelleitungen sind, die jeweils eine Mehrzahl von Einzelleitungen umfassen mögen.

Der zentrale Prozessorteil Pr ist eingangsseitig mit weiteren Parallelleitungen Lkm verbunden, über die dem betreffenden Prozessorteil Parallelsignale zugeführt werden können. Die Parallelleitungen Lkm sind ebenso wie die Parallelleitungen Lgm im vorliegenden Fall mit entsprechenden Anschlüssen einer weiteren Verarbeitungseinrichtung verbunden, welche Parallelsignale aufzunehmen bzw. abzugeben vermag, die jeweils m Bits umfassen.

Der zentrale Prozessorteil Pr des Mikrocomputers bzw. Mikroprozessors MC ist mit weiteren Parallelausgängen mit den Eingängen von Schieberegisterstufen eines weiteren internen Registers Reg2 verbunden. Dieses interne Register Reg2, welches auch durch einen internen Speicher des Mikrocomputers gebildet sein mag, dient zur Aufnahme der nach Verarbeitung von dem zentralen Prozessorteil Pr abgegebenen Parallelsignale. Die einzelnen Bits dieser Parallelsignale werden vom Ausgang des Registers Reg2 seriell an die einen Eingänge von UND-Gliedern G1, G2 und G3 abgegeben, die an ihren anderen Eingängen Steuersignale von einer Steuerschaltung Con her zugeführt erhalten, die
ferner zur Steuerung der oben bereits erwähnten Multiplexerschaltung Mux dient. Diese Steuerschaltung Con ist
eingangsseitig mit einem Ausgang des zentralen Prozessorteiles Pr verbunden. Über diese Verbindung erhält die
Steuerschaltung Con die für ihre Steuerungsaufgaben erforderlichen Informationssignale zugeführt. Durch die an die
UND-Glieder G1, G2, G3 abgegebenen Steuersignale wird bewirkt, daß jeweils nur eines dieser UND-Glieder in den
übertragungsfähigen Zustand gelangt. Durch die an die
Multiplexerschaltung Mux abgegebenen Steuersignale wird
diese Multiplexerschaltung jeweils so eingestellt, daß
stets nur der Ausgang eines der bistabilen Kippglieder
Ke1, Ke2, Ke3 mit dem Eingang se des Mikrocomputers bzw. Mikroprozessors MC verbunden ist. Mit anderen
Worten ausgedrückt heißt dies, daß durch die Steuerschaltung Con eine solche Steuerung erfolgt, daß jeweils nur
eine der Signalaufnahmeleitungen e1, e2, e3 und zugleich
auch nur eine der Signalabgabeleitungen a1, a2, a3 für
eine Signalübertragung zu bzw. von dem Mikrocomputer bzw.
Mikroprozessor MC1 wirksam ausgenutzt ist. Die Steuerschaltung Con kann beispielsweise durch den Befehlsdecoder des
Mikrocomputers bzw. Mikroprozessors MC gebildet sein.

Die Aufnahme der einzelnen Bits der jeweils seriell auftretenden Binärsignale durch die bistabilen Kippglieder
Ke1 bis Ke3 und Ka1 bis Ka3 erfolgt jeweils taktgesteuert.
Die dazu über den Taktanschluß t1 zugeführten Taktimpulse,
die mit einer Taktrate T1 auftreten mögen, werden ferner
sowohl dem Zähleingang des Zählers Cnt als auch einem
Steuereingang des Mikrocomputers bzw. Mikroprozessors MC
zugeführt. Bei diesem Steuereingang mag es sich um einen
üblichen Unterbrechungseingang (INT) des betreffenden
Mikrocomputers bzw. Mikroprozessors handeln. Auf die Zuführung derartiger Steuersignale hin mag der betreffende
Mikrocomputer bzw. Mikroprozessor MC in der Weise reagieren, daß er das am Eingang se gerade anstehende Bit in
das Register Reg1 übernimmt und/oder die Bits eines Parallelsignals, welches einer Verarbeitung unterzogen worden ist, an die in Frage kommende Signalabgabeleitung al bzw. a2 bzw. a3 (über das Register Reg2) abgibt. Die Übernahme der in dem Register Reg1 aufgesammelten Bits in den Mikroprozessor bzw. Mikrocomputer erfolgt auf dessen Ansteuerung vom Ausgang des Zählers Cnt her.

Im Zuge der vorstehenden Erläuterungen ist ganz allgemein davon ausgegangen worden, daß der Mikrocomputer bzw. Mikroprozessor MC Binärsignale seriell über eine der Signalaufnahmeleitungen e1 bis e3 aufnimmt und Binärsignale seriell über eine der Signalabgabeleitungen al bis a3 abgibt. Die Informationen darüber, um welche Signalaufnahmeleitung und um welche Signalabgabeleitung es sich dabei handelt, steht der bereits erwähnten Steuerschaltung Con zur Verfügung.

Wie oben bereits angedeutet, kann die betreffende Information der Steuerschaltung Con von dem zentralen Prozessorteil Pr zur Verfügung gestellt werden. Dies setzt indessen voraus, daß der zentrale Prozessorteil Pr zuvor entsprechende Informationssignale zugeführt erhalten hat. Derartige Informationssignale können dem zentralen Prozessorteil Pr beispielsweise über die Parallelleitungen Lkm zugeführt sein. Es ist aber auch denkbar, daß der betreffende zentrale Prozessorteil Pr derartige Informationssignale dadurch gewinnt, daß er über die Steuerschaltung Con zunächst die Multiplexerschaltung Mux in einem Suchlauf arbeiten läßt. Dabei werden die Ausgänge der bistabilen Kippglieder Ke1 bis Ke3 nacheinander mit dem Eingang se verbunden. Wenn am Eingang einer der betreffenden bistabilen Kippglieder Ke1 bis Ke3 ein Signalzustandswechsel auftritt, dann kann die Steuerschaltung Con die Multiplexerschaltung Mux in der zuletzt erreichten Stellung eingestellt lassen. In dieser Stellung gelangen dann die über eine der Signalaufnahmeleitungen e1 bis e3 seriell auftretenden Bits nacheinander in den Mikrocomputer bzw.

Mikroprozessor MC hinein. Die Steuerschaltung Con kann dabei ferner so ausgebildet sein, daß sie zugleich eine Verbindung über eines der UND-Glieder G1 bis G3 wirksam steuert. Geht man davon aus, daß die mit den Signalaufnahmeleitungen e1 bis e3 ausgangsseitig verbundenen Datenendgeräte eingangsseitig auch mit jeweils einer der Signalabgabeleitungen a1 bis a3 verbunden sein werden, so wird jeweils dasjenige UND-Glied der UND-Glieder G1 bis G3 wirksam gesteuert, über das Binärsignale seriell an die jeweils zugehörige Signalabgabeleitung weitergeleitet werden können. So können beispielsweise jeweils die beiden Leitungen e1 und a1 oder die beiden Leitungen e2 und a2 oder die beiden Leitungen e3 und a3 mit dem Mikrocomputer bzw. Mikroprozessor MC wirksam verbunden sein.

Abschließend sei noch angemerkt, daß gemäß der vorliegenden Erfindung auch so vorgegangen werden kann, daß die auf sämtlichen oder einer Mehrzahl der Signalaufnahmeleitungen auftretenden Signale zeitlich unmittelbar nacheinander über die entsprechend schnell umgesteuerte Multiplexerschaltung Mux dem Mikroprozessor bzw. Mikrocomputer MC zur Verarbeitung zugeführt werden. Die Umsteuerung der Multiplexerschaltung erfolgt dabei nach Zeitabschnitten, die jeweils kürzer sind als die Dauer zwischen zwei Taktimpulsen, die am Taktanschluß t1 auftreten. Die dadurch erhaltenen Abtastwerte bzw. Signalbits können in gesonderten Registern bzw. Speichern des Mikroprozessors bzw. Mikrocomputers MC abgespeichert werden.

4 Patentansprüche
1 FIGUR

- 11 -    VPA   84 P 1423 E

Patentansprüche

1. Schaltungsanordnung zur Aufnahme von auf einer Mehrzahl
von Signalaufnahmeleitungen (e1, e2, e3) seriell auftretenden Binärsignalen und Verarbeitung dieser Binärsignale in
Form von jeweils eine vorgegebene Anzahl von Bits umfassenden Parallelsignalen und/oder zur Abgabe von seriell auftretenden Binärsignalen über einzelne Signalabgabeleitungen (a1, a2, a3) nach zuvor erfolgter Verarbeitung von jeweils die vorgegebene Anzahl von Bits umfassenden Parallelsignalen in bzw. von einer einen Mikrocomputer bzw. Mikroprozessor (MC) enthaltenden Verarbeitungseinrichtung, die
eingangs- und /oder ausgangsseitig über Signalaufnahme-
bzw. Signalabgabeeinrichtungen (Ke1 bis Ke3, Ka1 bis Ka3)
mit den Signalaufnahme- bzw. Signalabgabeleitungen (e1
bis e3; a1 bis a3) verbunden ist,
d a d u r c h   g e k e n n z e i c h n e t ,
daß die Signalaufnahmeeinrichtungen durch den Signalaufnahmeleitungen (e1 bis e3) individuell zugehörige bistabile Kippglieder (Ke1 bis Ke3) gebildet sind, welche taktgesteuert die auf den einzelnen Signalaufnahmeleitungen (e1
bis e3) auftretenden Bits aufnehmen und die betreffenden
Bits ausgangsseitig über eine Auswahlschaltung (Mux) an
einen Eingang (se) des ebenfalls taktgesteuerten
Mikrocomputers bzw. Mikroprozessors (MC) abzugeben gestatten,
daß dem betreffenden Eingang (se) in dem Mikrocomputer bzw.
Mikroprozessor (MC) wenigstens ein interner Speicher bzw.
wenigstens ein internes Register (Reg1) zur Aufnahme der seriell
auftretenden Bits in einzelnen Speicher- bzw. Registerzellen
und zur Abgabe jeweils eines Parallelsignals für die Verarbeitung
nach Aufnahme von Bits in der genannten vorgegebenen Anzahl zugeordnet ist
und daß die Signalabgabeeinrichtungen durch einzelne, ebenfalls taktgesteuerte bistabile Kippglieder (Ka1 bis Ka3)
gebildet sind, welche ausgangsseitig jeweils direkt mit den einzelnen Signalabgabeleitungen (al bis a3) verbunden
sind und welche eingangsseitig die von der Ausgangsseite
des Mikrocomputers bzw. Mikroprozessors (MC) seriell bereitgestellten Bits aufnehmen, die aus einzelnen Speicher-
bzw. Registerzellen wenigstens eines in dem Mikrocomputer bzw.
Mikroprozessor (MC) als Abgabespeicher bzw. Abgaberegister vorgesehenen internen Speichers bzw. Registers (Reg2) abgegeben werden, der bzw. das auf entsprechende Verarbeitungsvorgänge hin Parallelsignale zugeführt erhält.

2. Schaltungsanordnung nach Anspruch 1, d a d u r c h
g e k e n n z e i c h n e t , daß die die Signalabgabeeinrichtungen bildenden bistabilen Kippglieder (Kal bis
Ka3) mit ihren Signaleingängen an einzelne Ausgänge des
Mikrocomputers bzw. Mikroprozessors (MC) angeschlossen
sind, welche durch individuelle Aktivierung jeweils einzeln mit dem genannten Ausgabespeicher bzw. -register
(Reg2) verbindbar sind.

3. Schaltungsanordnung nach Anspruch 1, d a d u r c h
g e k e n n z e i c h n e t , daß die mit der Ausgangsseite der die Signalaufnahmeeinrichtungen bildenden bistabilen Kippglieder (Kel bis Ke3) verbundene Auswahlschaltung (Mux) durch eine Multiplexerschaltung (Mux) gebildet
ist, welche durch eine Steuerschaltung (Con) gesteuert
jeweils nur eines der betreffenden bistabilen Kippglieder
(Kel bis Ke3) mit dem Eingang (se) des Mikrocomputers bzw. Mikroprozessors (MCl) wirksam verbindet.

4. Schaltungsanordnung nach Anspruch 3, d a d u r c h
g e k e n n z e i c h n e t , daß die Multiplexerschaltung (Mux) eingangsseitig an zu zwei Gruppen von Signalaufnahmeleitungen gehörende Signalaufnahmeleitungen angeschlossen ist und aus jeder Gruppe der betreffenden Signalaufnahmeleitungen jeweils eine Signalaufnahmeleitung
auszuwählen gestattet,

- 13 -    VPA 84 P 1423 E

und daß die Multiplexerschaltung (Mux) ausgangsseitig mit zwei gesonderten Eingängen des Mikrocomputers bzw. Mikroprozessors verbunden ist.